# EUROPEAN PATENT SPECIFICATION

(11) **EP 3 157 027 B1**
(45) Date of publication and mention of the grant of the patent: **07.09.2022**
(21) Application number: 15806919.5
(22) Date of filing: 11.06.2015
(51) Int. Cl.: H01G 9/20, C01B 32/174, B82B 1/00, C01B 32/158, H01L 27/30

(54) **COUNTER ELECTRODE FOR DYE-SENSITIZED SOLAR CELL, DYE-SENSITIZED SOLAR CELL, AND SOLAR CELL MODULE**
GEGENELEKTRODE EINER FARBSTOFFSENSIBILISIERTEN SOLARZELLE, FARBSTOFFSENSIBILISIERTE SOLARZELLE UND SOLARZELLENMODUL
ÉLECTRODE OPPOSÉE DE CELLULE SOLAIRE À COLORANT, CELLULE SOLAIRE À COLORANT ET MODULE À CELLULE SOLAIRE

(30) Priority: 13.06.2014 JP 2014122465
(43) Date of publication of application: 19.04.2017
(73) Proprietor: Zeon Corporation, Tokyo 100-8246 (JP)
(72) Inventor: YOSHIWARA, Akihiko, Tokyo 100-8246 (JP)
(74) Representative: Maiwald Patent- und Rechtsanwaltsgesellschaft mbH
(86) International application number: PCT/JP2015/002933
(87) International publication number: WO 2015/190108

(56) References cited:
- EP-A1- 1 787 955
- EP-A1- 3 053 879
- EP-A1- 3 089 247
- WO-A1-2013/133292
- WO-A1-2013/169004
- WO-A1-2015/045418
- JP-A- 2005 154 200
- JP-A- 2015 128 099
- JP-A- 2015 146 227
- US-A1- 2008 299 374
- WON JAE LEE ET AL: "Efficient Dye-Sensitized Solar Cells with Catalytic Multiwall Carbon Nanotube Counter Electrodes", ACS APPLIED MATERIALS & INTERFACES, vol. 1, no. 6, 24 June 2009 (2009-06-24), pages 1145-1149, XP055438286, US ISSN: 1944-8244, DOI: 10.1021/am800249k
- MARTINEZ M T ET AL: "Sensitivity of single wall carbon nanotubes to oxidative processing: structural modification, intercalation and functionalisation", CAR, ELSEVIER, OXFORD, GB, vol. 41, no. 12, 1 January 2003 (2003-01-01), pages 2247-2256, XP004453476, ISSN: 0008-6223, DOI: 10.1016/S0008-6223(03)00250-1
- HONG-ZHANG GENG ET AL.: 'Effect of Acid Treatment on Carbon Nanotube-Based Flexible Transparent Conducting Films' J. AM. CHEM. SOC. vol. 129, 31 May 2007, pages 7758 - 7759, XP055244502

## Description

### TECHNICAL FIELD

This disclosure relates to a counter electrode for dye-sensitized solar cell which is superior in catalytic activity and is also suitable for mass production, a dye-sensitized solar cell including the counter electrode, and a solar cell module obtained using the dye-sensitized solar cell.

### BACKGROUND ART

Recently, solar cells have attracted attention as photoelectric conversion elements that convert light energy to electric power. Among solar cells, dye-sensitized solar cells have received particular attention for their potential in weight reduction compared to silicon and other types of solar cells, capability of stable electricity generation over a wide illumination range, and availability of relatively inexpensive materials for manufacture without the need for large-scale equipment.

A dye-sensitized solar cell normally has a structure in which a photoelectrode, an electrolyte layer, and a counter electrode are arranged in the order stated. In the dye-sensitized solar cell, electrons are taken out from a sensitizing dye in the photoelectrode when the sensitizing dye is excited upon receipt of light. These electrons move out of the photoelectrode, pass through an external circuit to the counter electrode, and move into the electrolyte layer through the catalyst layer of the counter electrode.

As the catalyst layer of the counter electrode of such a dye-sensitized solar cell, platinum thin films have been widely used. Recently, however, for further reductions in production costs, research and development have been earnestly made on materials which are possible alternatives to materials for the catalyst layer of the counter electrode.

For example, PTL 1 proposes a counter electrode that contains, as catalyst material, fine linear or cylindrical carbon material, at least a part of which is covered with a conductive polymer.

PTL 2, which is prior art pursuant to Art. 54(3) EPC, discloses a conductive film including carbon nanotubes having an average diameter (Av) and a diameter standard deviation (Ã) satisfying a relationship 0.60 > (3Ã/Av) > 0.20 and a conductive carbon that is different from the carbon nanotubes. A content ratio of the carbon nanotubes relative to the conductive carbon (carbon nanotubes/conductive carbon) is from 1/99 to 99/1 as a mass ratio.

PTL 3, which is prior art pursuant to Art. 54(3) EPC, discloses carbon nanotubes that can be used in various materials and a dispersion liquid thereof

PTL 4 discloses a method of manufacturing a transparent electrode having a carbon nanotube.

NPL1 discloses dye-sensitized solar cell counter electrodes comprising carbon nanotubes.

### CITATION LIST

### Patent Literature

PTL 1: JP 2008-71605A
PTL 2: EP 3 089 247 A1
PTL 3: EP 3 053 879 A1
PTL 4: US 2008/0299374 A1

NPL1: Lee et al., Applied Materials & Interfaces; VOL 1, Nr. 6, pages 1145-1149; XP055438286

### SUMMARY

### (Technical Problem)

Manufacture of the counter electrode described in PTL 1, however, requires a separate step of covering carbon material such as carbon nanotubes with a conductive polymer. Accordingly, there has been a need for readily-manufacturable, high-performance counter electrodes for dye-sensitized solar cell.

This disclosure was conceived in light of such a circumstance pertinent in the art and aims to provide a counter electrode for dye-sensitized solar cell which is superior in catalytic activity and is also suitable for mass production, a dye-sensitized solar cell including the counter electrode, and a solar cell module obtained using the dye-sensitized solar cell.

### (Solution to Problem)

The inventors made extensive studies to solve the aforementioned problem. As a consequence, they have established that a counter electrode for dye-sensitized solar cell having a catalyst layer containing carbon nanotubes (hereinafter occasionally referred to as "CNTs") having specific ranges of carbon monoxide desorption and carbon dioxide desorption as measured at from 150°C to 950°C in temperature programmed desorption is superior in catalytic activity and further suitable for mass production. The inventors thus completed this disclosure.

According to this disclosure, there is provided counter electrodes for dye-sensitized solar cell given in the following items (1) to (5), a dye-sensitized solar cell given in the following item (6), and a solar cell module given in the following item (7).
(1) A counter electrode for dye-sensitized solar cell, including:
   a support; and
   a catalyst layer formed on or over the support,
   wherein the catalyst layer contains at least carbon nanotubes having a carbon monoxide desorption of 400 µmol/g to 1,000 µmol/g and a carbon dioxide desorption of 200 µmol/g to 600 µmol/g, as measured at from 150°C
   to 950°C in temperature programmed desorption, wherein
   the catalyst layer has a solid zeta-potential of +20 mV to -20 mV and contains the carbon nanotubes in an amount of 5 mg/m² to 1 × 10³ mg/m², and
   the carbon nanotubes are sulfuric acid-treated carbon nanotubes.
(2) The counter electrode for dye-sensitized solar cell of item (1), wherein the carbon nanotubes satisfy the condition 0.20<(3σ/Av)<0.60, where Av is an average diameter of the carbon nanotubes, and σ is a standard deviation of diameters of the carbon nanotubes.
(3) The counter electrode for dye-sensitized solar cell of any one of item (1) or (2), wherein the catalyst layer has a thickness of 0.005 µm to 100 µm.
(4) The counter electrode for dye-sensitized solar cell of any one of items (1) to (3), wherein the catalyst layer further contains conductive carbon which is different from the carbon nanotubes.
(5) The counter electrode for dye-sensitized solar cell of item (4), wherein a mass content ratio of the carbon nanotubes to the conductive carbon (carbon nanotubes/conductive carbon) is 1/99 to 99/1.
(6) A dye-sensitized solar cell including, in order:
   a photoelectrode;
   an electrolyte layer; and
   a counter electrode,
   wherein the counter electrode is the counter electrode for dye-sensitized solar cell of any one of items (1) to (5).
(7) A solar cell module including the dye-sensitized solar cells of item (6) connected in series and/or parallel.

### (Advantageous Effect)

According to this disclosure, there is provided a counter electrode for dye-sensitized solar cell which is superior in catalytic activity and further suitable for mass production, a dye-sensitized solar cell including the counter electrode, and a solar cell module obtained using the dye-sensitized solar cell.

### BRIEF DESCRIPTION OF THE DRAWINGS

In the accompanying drawings:

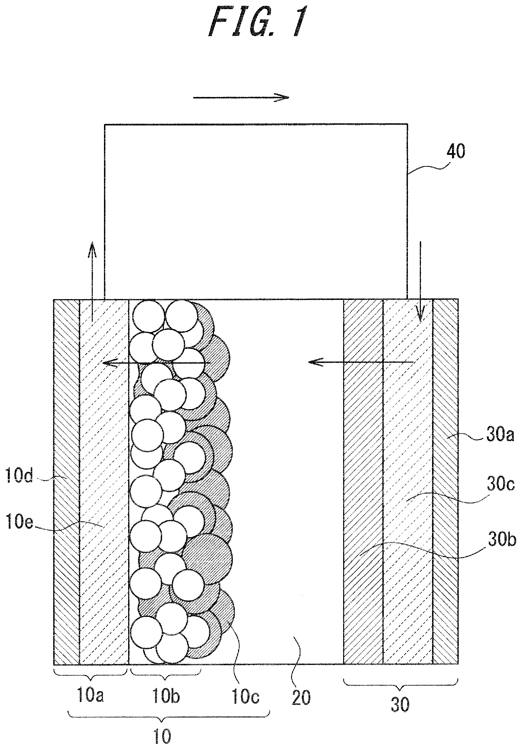

FIG. 1 illustrates a structure of an example of a dye-sensitized solar cell disclosed herein.

### DETAILED DESCRIPTION

An embodiment of this disclosure will now be described in detail in regard to 1) counter electrode for dye-sensitized solar cell, and 2) dye-sensitized solar cell and solar cell module.

### 1) Counter Electrode for Dye-Sensitized Solar Cell

A counter electrode for dye-sensitized solar cell (hereinafter occasionally referred to as "counter electrode disclosed herein") include a support and a catalyst layer formed on or over the support, the catalyst layer containing at least carbon nanotubes. The carbon nanotubes contained in the catalyst layer of the counter electrode disclosed herein have a carbon monoxide desorption of 400 µmol/g to 1,000 µmol/g and a carbon dioxide desorption of 200 µmol/g to 600 µmol/g, as measured at from 150°C to 950°C in temperature programmed desorption. The catalyst layer has a solid zeta-potential of +20 mV to -20 mV and contains the carbon nanotubes in an amount of 5 mg/m2 to 1 × 10³ mg/m², and the carbon nanotubes are sulfuric acid-treated carbon nanotubes. Hereinafter, carbon nanotubes used herein which have the amounts of CO and CO₂ desorption described above are occasionally referred to as "carbon nanotubes A."

As used herein, "carbon nanotubes A" is a collective term for a population of specific carbon nanotubes.

### [Support]

The support serves to support thereon the catalyst layer. In this disclosure the carbon nanotubes (A) constituting the catalyst layer have electrical conductivity and therefore a conductive film is not necessarily required between the support and catalyst layer. From the perspective of ensuring good electrical conduction, however, a conductive film is preferably formed at least on a part of the surface of the support where the catalytic layer may make contact.

Examples of usable supports include conductive sheets formed using metals, metal oxides, carbon materials, conductive polymers or the like, and non-conductive sheets made of resin or glass. In particular, non-conductive sheets made of resin or glass are preferred for their capability to efficiently form a lightweight, superior conversion efficiency dye-sensitized solar cell, with sheets made of transparent resin being more preferred for their easiness with which a lightweight, inexpensive, superior conversion efficiency dye-sensitized solar cell can be obtained.

Examples of transparent resins used include synthetic resins such as polyethylene terephthalate (PET), polyethylene naphthalate (PEN), syndiotactic polystyrene (SPS), polyphenylene sulfide (PPS), polycarbonate (PC), polyarylate (PAr), polysulfone (PSF), polyester sulfone (PES), polyetherimide (PEI), transparent polyimide (PI), and cycloolefin polymer (COP).

Examples of the conductive layer include those made of metal such as platinum, gold, silver, copper, aluminum, indium or titanium; conductive metal oxide such as tin oxide or zinc oxide; composite metal oxide such as indium tin oxide (ITO) or indium zinc oxide (IZO); carbon material such as carbon nanotubes other than the carbon nanotubes (A) or graphene; or any combination thereof.

The conductive film preferably has a surface resistivity of 500Ω/square or less, more preferably 150 Ω/square or less, and still more preferably 50 Ω/square or less.

The conductive film can be formed by any of the methods known in the art, such as sputtering or coating.

The thickness of the support may be appropriately determined according to the intended application: however, the support is normally 10 µm to 10,000 µm.

The support preferably has an optical transmittance (measurement wavelength: 500 nm) of 60% or more, more preferably 75% or more, and still more preferably 80% or more. When the support has a light transmittance of 60% or more, it is possible to provide a dye-sensitized solar cell having a superior conversion efficiency.

### [Catalyst Layer]

The catalyst layer contains the carbon nanotubes (A). The catalyst layer functions as a catalyst when electrons are transported from the counter electrode to the electrolyte layer in a dye-sensitized solar cell. The catalyst layer has electrical conductivity and therefore also has a function as a conductive film. The catalyst layer may further contain conductive carbon other than the carbon nanotubes (A). The catalyst layer may also contain nanoparticles of platinum or the like, a polythiophene polymer such as poly(3,4-ethylenedioxythiophene)(PEDOT), and/or the like.

### [Carbon Nanotubes (A)]

The carbon nanotubes (A) constituting the catalyst layer have a carbon monoxide (CO) desorption of 400 µmol/g to 1,000 µmol/g and a carbon dioxide (CO₂) desorption of 200 µmol/g to 600 µmol/g, as measured at from 150°C to 950°C in temperature programmed desorption.

CO and CO₂ present in gas produced during temperature programmed desorption originate from various functional groups bonded to the surfaces of the CNTs, such as hydroxyl group, carboxyl group, ketone group, lactone group, aldehyde group, and methyl group. The carbon nanotubes (A) have the amounts of CO and CO₂ desorption described above, and it is presumed that particularly hydroxyl groups and carboxyl groups are present in higher amounts on the surface of the carbon nanotubes (A). Because of such characteristics, the carbon nanotubes (A) exhibit, for example, superior dispersibility in various solvents as well as superior electrical conductivity and reliability. Hence, a catalyst layer containing the carbon nanotubes (A) having the amounts of CO and CO₂ desorption described above exerts superior catalytic activity.

From the perspective of increasing the catalytic activity of the catalyst layer containing the carbon nanotubes (A), the amount of CO desorption is preferably 500 µmol/g or more, more preferably 550 µmol/g or more, preferably 900 µmol/g or less, more preferably 850 µmol/g or less, and still more preferably 750 µmol/g or less. From the perspective of increasing the catalytic activity of the catalyst layer containing the carbon nanotubes (A), the amount of CO₂ desorption is preferably 210 µmol/g or more, preferably 500 µmol/g or less, and more preferably 270 µmol/g or less.

The amounts of CO and CO₂ desorption in temperature programmed desorption can be obtained through a commonly known method. More specifically, adsorbed water is first desorbed from the surfaces of the CNTs by heat treatment of the CNTs in a given temperature programmed desorption device. Next, the heat treated CNTs are heated to a given temperature in an inert gas such as helium gas, and the amounts of CO and CO₂ that are produced due to desorption of functional groups (e.g., oxygen atom-containing compounds) from the surfaces of the CNTs are quantified.

The amount of CO desorption or CO₂ desorption at from 150°C to 950°C in temperature programmed desorption is obtained by initially heating the CNTs to 150°C and then measuring the total amount of CO or the total amount of CO₂ that is desorbed when the CNTs are further heated to 950C°.

The carbon nanotubes (A) described above are produced by oxidizing arbitrary CNTs (hereinafter occasionally referred to as "feedstock CNTs") on their surface. Specifically, the carbon nanotubes (A) are produced by subjecting the surface of feedstock CNTs to oxidization treatment using sulfuric acid or sulfuric acid and nitric acid.

The amounts of CO desorption or CO₂ desorption can be adjusted by appropriately changing the condition used for oxidization treatment of CNTs in the manner described below.

### -Sulfuric Acid Treatment-

Feedstock CNTs can be subjected to any surface treatment using sulfuric acid (oxidization treatment), and sulfuric acid with a purity of 96% or more is normally used. Sulfuric acid is normally added in an amount of 200 parts by mass to 10,000 parts by mass per 100 parts by mass of feedstock CNTs. At the time of addition, the resultant mixture may be subjected to ultrasonic treatment to disperse the feedstock CNTs. Thereafter, the resultant mixture may be heated. Any heating method can be used as long as it is commonly used, and the heating method may be selected as appropriate from among methods such as heating in an oil bath or a heating mantle, and heating by microwave irradiation. Heating may be performed at normal pressure or under increased pressure in an autoclave or the like. Heating by means of oil bath or heating mantle is normally performed for 0.1 hours to 50 hours at 30°C to 120°C at normal pressure, whereas at increased pressure, it is normally performed for 0.1 hours to 50 hours at 30°C to 200°C. On the other hand, heating by microwave irradiation is normally performed by setting microwave output such that the above-described mixture is heated for 0.01 hours to about 24 hours at 30°C to 120°C for heating at normal pressure, and at 30°C to 200°C for heating at increased pressure. In any of the cases described above, heating may be performed in one stage or may be performed in two or more stages. The mixture is preferably stirred during heating by a commonly known stirring means. Pressure application is normally performed in a range from normal pressure to 30 MPa.

By the operation described above, the feedstock CNTs are treated with sulfuric acid on their surface. The resultant mixture after is cooled to room temperature because the mixture is extremely hot upon completion of the treatment. Next, sulfuric acid is for example removed by decantation and the treated CNTs are for example washed with water. Washing is normally performed until washing waste water is neutral.

It is assumed that as a result of the CNTs being surface-treated with sulfuric acid, in addition to the above-described functional groups, sulfo groups (-SO₃H) will become bonded to the surface of the CNTs. The presence of such sulfo groups makes a significant contribution toward improving electrical conductivity and dispersibility of the CNTs.

### -Nitric Acid Treatment-

Any nitric acid can be used for the surface treatment of feedstock CNTs using nitric acid (nitric acid treatment) as long as it contains nitric acid, and it encompasses fuming nitric acid. The nitric acid that is used normally has a purity of 5% or more, preferably 50% or more, and more preferably 80% or more. Nitric acid is normally added in an amount of 200 parts by mass to 10.000 parts by mass per 100 parts by mass of feedstock CNTs. At the time of addition, the resultant mixture may be subjected to ultrasonic treatment to disperse the feedstock CNTs. Thereafter, the resultant mixture may be heated. Any heating method can be used as long as it is commonly used, and the heating method may be selected as appropriate from among methods such as heating in an oil bath or a heating mantle, and heating by microwave irradiation. Heating may be performed at normal pressure or under increased pressure in an autoclave or the like. Heating by means of oil bath or heating mantle is normally performed for 0.1 hours to 50 hours at 30°C to 120°C at normal pressure, whereas at increased pressure, it is normally performed for 0.1 hours to 50 hours at 30°C to 200°C. On the other hand, heating by microwave irradiation is normally performed by setting microwave output such that the above-described mixture is heated for 0.01 hours to about 24 hours at 30°C to 120°C for heating at normal pressure, and at 30°C to 200°C for heating at increased pressure. In any of the cases described above, heating may be performed in one stage or may be performed in two or more stages. The mixture is preferably stirred during heating by any appropriate stirring means. Pressure application is normally performed in a range from normal pressure to 30 MPa.

By the operation described above, the feedstock CNTs are treated with nitric acid on their surface. The resultant mixture after is cooled to room temperature because the mixture is extremely hot upon completion of the treatment. Next, nitric acid is for example removed by decantation and the treated CNTs are for example washed with water. Washing is normally performed until washing waste water is neutral.

It is assumed that as a result of the CNTs being surface-treated with nitric acid, in addition to the above-described functional groups, nitro groups (-NO₂) will become bonded to the surface of the CNTs. The presence of such nitro groups makes a significant contribution toward improving electrical conductivity and dispersibility of the CNTs.

The feedstock CNTs may be single-walled or multi-walled CNTs. However, from the perspective of improving performance (e.g., electrical conductivity and mechanical strength) of the resultant CNTs, the feedstock CNTs are preferably single- to 5-walled CNTs, with single-walled CNTs being more preferable. From a similar perspective, the feedstock CNTs are preferably CNTs produced by the super growth method described later (hereinafter occasionally referred to as "SGCNTs").

From the perspective of improving the catalytic activity of the catalyst layer, the carbon nanotubes (A) preferably have the following property in addition to the amounts of CO and CO₂ desorption described above.

Specifically, as regards the carbon nanotubes (A), the ratio of (3σ) (standard deviation of diameters (σ) multiplied by 3) to average diameter (Av), (3σ/Av), is preferably greater than 0.20 to less than 0.60, more preferably greater than 0.25, and still more preferably greater than 0.50. When 3σ/Av is greater than 0.20 to less than 0.60. the catalytic activity of the catalyst layer can be sufficiently increased even when small amounts of CNTs are blended.

"Average diameter (Av) of carbon nanotubes" and "standard deviation (σ: sample standard deviation) of diameters of carbon nanotubes" are each obtained by measuring the diameters (outer diameters) of 100 randomly-selected carbon nanotubes under observation by transmission electron microscopy. The average diameter (Av) and the standard deviation (σ) of diameters of CNTs may be adjusted by changing the production method and/or condition of CNTs or by combining multiple types of CNTs obtained by different production methods.

The carbon nanotubes (A) are normally CNTs whose diameter distribution follows a normal distribution when the diameters measured as described above are plotted on a graph's horizontal axis and their frequency on the vertical axis and approximated by Gaussian distribution.

The carbon nanotubes (A) preferably exhibit a radial breathing mode (RBM) peak when evaluated by Raman spectroscopy. Note that an RBM is not present in the Raman spectrum of a multi-walled carbon nanotube having three or more walls.

In the Raman spectrum of the carbon nanotubes (A), a ratio of G band peak intensity relative to D band peak intensity (G/D ratio) is preferably 1 to 20. A G/D ratio of 1 to 20 enables superior electrical conductivity to be imparted even when small amounts of CNTs have been blended,

The G/D ratio refers to a measure commonly used for evaluating the quality of CNTs. In a Raman spectrum of CNTs measured by a Raman spectrometer, vibration modes referred to as a G band (near 1600 cm⁻¹) and a D band (near 1350 cm⁻¹) are observed. The G band is a vibration mode based on the hexagonal lattice structure of graphite forming cylindrical surfaces of the CNTs and the D band is a vibration mode based on amorphous locations. CNTs having a high peak intensity ratio of the G band and the D band (G/D ratio) are evaluated as being highly crystalline.

The carbon nanotubes (A) preferably have an average diameter (Av) of 0.5 nm or more, more preferably 1 nm or more, preferably 15 nm or less, and more preferably 10 nm or less. When the average diameter (Av) is 0.5 nm or more, dispersibility of the CNTs in the catalyst layer can be increased by suppressing aggregation of the CNTs. When the average diameter (Av) is 15 nm or less, the catalytic activity of the catalyst layer can be sufficiently increased.

The carbon nanotubes (A) preferably have an average length of 100 µm to 5,000 µm in terms of the structure when synthesized. When the average length of the CNT structures falls within the above-described range, a catalyst layer with high catalytic activity is easily formed. The longer the CNT structure when synthesized, the more likely CNTs are prone to damage such as fracture or breakage upon dispersing of the CNTs and/or generation of a catalyst layer. Accordingly, the average length of the CNT structures when synthesized is preferably 5,000 µm or less.

The carbon nanotubes (A) preferably have a BET specific surface area of 600 m²/g or more, preferably 800 m²/g or more, preferably 2,500 m²/g or less, and more preferably 1,200 m²/g or less. When the carbon nanotubes (A) are mainly formed of opened CNTs, the carbon nanotubes (A) preferably have a BET specific surface area of 1,300 m²/g or more. When the BET specific surface area is 600 m²/g or more, the catalytic activity of the catalyst layer can be sufficiently increased. When the BET specific surface area is 2,500 m²/g or less, dispersibility of the CNTs in the catalyst layer can be increased by suppressing aggregation of the CNTs.

"BET specific surface area" as used herein refers to a nitrogen adsorption specific area measured by the BET method.

With the super growth method described later, the carbon nanotubes (A) are obtained on a substrate having thereon a catalyst layer for growing carbon nanotubes as an "aligned CNT aggregate" wherein the carbon nanotubes are aligned in a direction substantially perpendicular to the substrate. The CNTs in the form of such an aggregate preferably have a mass density of 0.002 g/cm³ to 0.2 g/ cm³. CNTs having a mass density of 0.2 g/cm³ or less will have weakened binding so that the CNTs can be dispersed more uniformly. When the mass density is 0.002 g/cm³ or more, the unity of the CNTs improves, preventing the CNTs from becoming unbound and making the CNTs easier to handle.

The carbon nanotubes (A) preferably have micropores. In particular, the carbon nanotubes (A) preferably have micropores having a pore diameter of smaller than 2 nm. In terms of the amount of micropores present, the micropore volume as obtained through the method described below is preferably 0.40 mL/g or more, more preferably 0.43 mL/g or more, and still more preferably 0.45 mL/g or more, and normally has an upper limit on the order of 0.65 mL/g. With the presence of such micropores, aggregation of the CNTs is suppressed and dispersibility of the CNTs increases, so that a catalyst layer in which the CNTs are highly dispersed can be obtained particularly efficiently. The micropore volume can for example be adjusted through appropriate alteration of a preparation method and preparation conditions of the CNTs.

"Micropore volume (Vp)" can be calculated using Equation (I): Vp = (V/22,414) × (M/σ) by measuring a nitrogen adsorption isotherm of the CNTs at liquid nitrogen temperature (77 K) with the amount of adsorbed nitrogen at a relative pressure P/Po of 0.19 being defined as V, where P is a measured pressure at adsorption equilibrium, and P₀ is a saturated vapor pressure of liquid nitrogen at time of measurement. In Equation (1), M is a molecular weight of 28.010 of the adsorbate (nitrogen), and ρ is a density of 0.808 g/cm³ of the adsorbate (nitrogen) at 77 K. The micropore volume can for example be obtained using a "BELSORP (registered trademark in Japan, other countries, or both)-mini" (produced by Bel Japan Inc.).

The carbon nanotubes (A) having the properties described above and feedstock CNTs used for the preparation of the carbon nanotubes (A) can be efficiently produced for example by a method in which during synthesis of carbon nanotubes through chemical vapor deposition (CVD) by supplying a feedstock compound and a carrier gas onto a substrate having a catalyst layer for carbon nanotube manufacture on the surface thereof, the catalytic activity of the catalyst layer for CNT manufacture is dramatically improved by providing a trace amount of an oxidizing agent in the system (super growth method; see WO2006/011 655), wherein the catalyst layer is formed on the surface of the substrate through a wet process and a gas having acetylene as the main component (e.g., gas containing at least 50% by volume of acetylene) is used as a feedstock gas.

### [Conductive Carbon]

Conductive carbon which the catalyst layer may optionally contain is conductive carbon which is different from the carbon nanotubes (A) described above. Specifically, examples of the conductive carbon include carbon nanotubes other than the carbon nanotubes (A) (in other words, carbon nanotubes that do not have the amounts of CO and CO₂ desorption described above); and other types of conductive carbon other than carbon nanotubes, such as carbon (e.g., carbon black, activated carbon, coke, natural graphite, and synthetic graphite) particles, carbon nanohorn, and carbon nanofiber.

Conductive carbon particles are of any size. From the perspective of controlling the catalyst layer to have a proper thickness range, the conductive carbon particles preferably have an average primary particle diameter of 5 nm or more, more preferably 10 nm or more, more preferably 200 nm or less, more preferably 100 nm or less, still more preferably 50 nm or less, and particularly preferably 30 nm or less.

In particular, from the perspective of improving electrical conductivity, carbon black is preferred as the conductive carbon. Examples of carbon black include Ketjen black (registered trademark in Japan, other countries, or both), acetylene black, BLACK PEARL(registered trademark in Japan, other countries, or both), and VULCAN (registered trademark in Japan, other countries, or both). In particular, it is preferable to use Ketjen black as the conductive carbon for its superior electrical conductivity and durability. From the perspective of corrosion resistance, it is preferable to use acetylene black. Acetylene black has a graphite-like microcrystalline particle structure and a high carbon content compared to other types of carbon black, and therefore exhibits superior corrosion resistance.

The conductive carbon can be produced by any production method, and can be produced by common methods.

It is also preferable to use heat-treated carbon black as the conductive carbon. This results in conductive carbon which is superior in electrical conductivity as well as in corrosion resistance. The G band half width in a Raman spectrum of the heat-treated carbon black is preferably 55 cm⁻¹ or less, more preferably 52 cm⁻¹ or less, and particularly preferably 49 cm⁻¹ or less. Conductive carbon with higher crystallinity has a three-dimensional crystal lattice resembling the graphite structure. Carbon with a smaller G band half-width is more crystalline, more corrosion resistant, and has lesser impurities.

The "G band" refers to a vibration mode observed near 1600 cm⁻¹ in a Raman spectrum of carbon black as measured by a Raman spectrometer, and is the same as the G band observed in a Raman spectrum of the CNTs. The "half-width" is a value used to determine the broadness of a given absorption band and refers to the width of an absorption band at half the height of the peak of the absorption band.

Heat-treated carbon black whose G band half-width is 55 cm⁻¹ or less can be obtained by heat treating the carbon black described above at high temperatures of on the order of 1,500°C to 3,000°C. Heat treatment can be any length of time, and 1 to 10 hours will suffice.

In particular, when acetylene black is used as the conductive carbon, from the perspective of improving corrosion resistance, it is preferable to use acetylene black whose G band half-width in a Raman spectrum is preferably 55 cm⁻¹ or less, more preferably 52 cm⁻¹ or less, and particularly preferably 49 cm⁻¹ or less.

The conductive carbon content in the catalyst layer is preferably such that the mass content ratio of the carbon nanotubes (A) to conductive carbon which is different from the carbon nanotubes (A) (carbon nanotubes (A)/conductive carbon) is 99/1 to 1/99, more preferably 95/5 to 20/80, still more preferably 90/10 to 40/60, and particularly preferably 80/20 to 50/50. When the content of conductive carbon different from the carbon nanotubes (A) falls within any of the ranges described above, it is possible to further increase the catalytic activity of the catalyst layer.

### [Properties of Catalyst Layer]

The catalyst layer contains the carbon nanotububes (A) as the constituent material and therefore has sufficient activity even without metal. Hence, the catalyst layer may not contain metal. However, the constituent material of the catalyst layer may be the carbon nanotubes (A) on which a trace amount of nanosized platinum or the like is supported; in this case, improvements in catalytic effect is expected. Metal can be supported on carbon nanotubes in accordance with any method known in the art.

The catalyst layer preferably has a thickness of 0.005 µm or more, more preferably 0.01 µm or more, still more preferably 0.1 µm or more, preferably 100 µm or less, more preferably 50 µm or less, still more preferably 5 µm or less, and particularly preferably 2 µm or less.

The amount of the carbon nanotubes (A) contained in the catalyst layer is 5 mg/ m² or more, and 1 × 10³ mg/m² or less.

Further, the catalyst layer preferably has a solid zeta-potential of -20 mV to +20 mV, and more preferably -10 mV to +10 mV. In general, it is suitable that the solid zeta-potential is negative. When the catalytic layer has a solid zeta-potential that falls within any of the ranges, the catalyst layer shows good affinity for the electrolysis solution and has superior catalytic performance, durability and the like.

When at least one of the catalyst layer thickness, the amount of the carbon nanotubes (A) contained in the catalyst layer, and the solid zeta-potential of the catalyst layer falls within their range described above, the catalytic activity of the catalyst layer can be advantageously further improved.

The solid zeta-potential of the catalyst layer can be measured for example with a zeta-potential meter for solid specimen ("SurPASS", from Anton Paar). The solid zeta-potential of the catalyst layer can be adjusted by changing the type and amount of the CNTs to be used for the catalyst layer.

### [Counter Electrode]

The counter electrode disclosed herein can be manufactured for example by preparing a dispersion liquid containing the carbon nanotubes (A), applying the dispersion liquid onto a support, and drying the resulting coating film to form a catalyst layer. Optionally, the dispersion liquid may further contain, in addition to the nanoparticles and polythiophene polymer described above, conductive carbon which is different from the carbon nanotubes (A).

The dispersion liquid can be applied by any method known in the art, such as using a bar coater, transfer coating, spin coating, spray coating, inkjet printing, or screen printing.

Any method can be used for drying the dispersion liquid applied; natural drying such as air drying, hot-air drying using an oven or the like, drying using a heating plate such as a hot plate, infrared irradiation, vacuum drying, or any combination thereof can be used. Drying temperature is normally from room temperature to 300°C or below, preferably 200°C or below, and more preferably 150°C or below. Drying humidity may be appropriately selected in accordance with drying temperature and can be set at any level; when drying temperature is for example around room temperature, drying humidity is generally 20% to 80% RH. Drying atmosphere may be appropriately selected from under inert gas atmosphere such as under nitrogen or argon gas, under vacuum, and under the ambient atmosphere.

Examples of solvents that used for the preparation of the dispersion liquid include water; alcohols such as methanol, ethanol, and propanol; ketones such as acetone and methyl ethyl ketone; ethers such as tetrahydrofuran, dioxane, and diglyme; amides such as N,N-dimethylformamide, N,N-dimethylacetamide, N-methyl-2-pyrrolidone, and 1,3-dimethyl-2-imidazolidinone; and sulfur-containing solvents such as dimethyl sulfoxide and sulfolane. These solvents may be used alone or in combination.

The dispersion liquid may further contain binders, conductive additives, dispersants, surfactants and the like within an extent that does not compromise the effects of this disclosure. Binders, conductive additives, dispersants, surfactants and the like known in the art may be used as appropriate.

The dispersion liquid can be obtained for example by mixing the carbon nanotubes (A) and where necessary other component(s) in solvent, and dispersing the carbon nanotubes.

Any treatment method known in the art can be utilized for mixing and dispersing. Examples of treatment methods include those that involve the use of a nanomizer, ultimizer, ultrasonic disperser, ball mill, sand grinder, dyno-mill, DCP mill, DCP mill, basket mill, paint conditioner, or high-speed stirring device.

The carbon nanotubes (A) can be added in any amount in the dispersion liquid. The carbon nanotubes (A) is preferably added in an amount of 0.001% by mass or more, more preferably 0.01% by mass or more, preferably 10% by mass or less, and more preferably 5% by mass or less of the total of the dispersion liquid.

The counter electrode disclosed herein is used as a counter electrode for dye-sensitized solar cell.

The counter electrode has a catalyst layer containing the carbon nanotubes (A) as the constituent material, and therefore, has superior catalytic activity.

The catalyst layer does not necessarily require expensive metals, so that the counter electrode can be manufactured at low costs. A high-quality catalyst layer can be efficiently formed through a simple operation using for example a dispersion liquid. Therefore, the counter electrode is superior in mass productivity.

### 2) Dye-Sensitized Solar Cell and Solar Cell Module

The dye-sensitized solar cell disclosed herein includes a photoelectrode, an electrolyte layer, and a counter electrode in the order stated, wherein the counter electrode is the counter electrode disclosed herein.

An example of the dye-sensitized solar cell disclosed herein is illustrated in FIG. 1.

The dye-sensitized solar cell illustrated in FIG. 1 has a structure in which a photoelectrode (transparent electrode) 10, an electrolyte layer 20, and a counter electrode 30 are arranged in the order stated. Arrows indicate the movement of electrons.

The photoelectrode 10 includes a photoelectrode base plate 10a, a porous semiconductor fine particulate layer 10b formed on the photoelectrode base plate 10a, and a sensitizing dye layer 10c formed by a sensitizing dye adsorbed onto the surface of the porous semiconductor fine particulate layer.

The photoelectrode base plate 10a functions as a support for the porous semiconductor fine particulate layer 10b, etc., and also functions as a current collector.

An example of the photoelectrode base plate 10a is for example obtained by stacking, on a support 10d formed of a transparent resin or glass sheet which has been exemplified as a support used in the counter electrode, a conductive film 10e made of a composite metal oxide such as indium tin oxide (ITO) or indium zinc oxide (IZO); carbon material such as carbon nanotubes (either same as or different from the carbon nanotubes (A) used in the catalyst layer of the counter electrode) or graphene; or metal material such as silver nanowires or metal mesh wires.

The porous semiconductor fine particulate layer 10b is a porous layer that contains semiconductor fine particles. As a result of the layer being porous, sensitizing dye adsorption can be increased and a dye-sensitized solar cell having a high conversion efficiency can be more easily obtained.

Examples of semiconductor fine particles include particles of metal oxides such as titanium oxide, zinc oxide, and tin oxide. Anatase-type titanium oxide is preferable.

The semiconductor fine particles preferably have a particle diameter (average particle diameter of primary particles) of 2 nm to 80 nm, more preferably 2 nm to 60 nm. Smaller particle diameters enable resistance reductions. Semiconductor fine particles of the same particle diameter may be used alone or semiconductor fine particles of different particle diameters may be used in combination.

The porous semiconductor fine particulate layer 10b can have any thickness and is normally 0.1 µm to 50 µm thick, more preferably 5 µm to 30 µm thick. These may be formed of a plurality of layers rather than a single layer.

The porous semiconductor fine particulate layer 10b can be formed by any method known in the art, such as press method, hydrothermal decomposition method, electrophoretic deposition method, or hinder-free coating method.

A semiconductor dense layer containing titanium, zinc, tin and the like may be formed between the porous semiconductor fine particulate layer 10b and conductive film 10e by sputtering, CVD, or sol-gel method.

The sensitizing dye layer 10c is a layer of a compound (sensitizing dye) that is adsorbed onto the surface of the porous semiconductor fine particulate layer 10b and that can transfer electrons to the porous semiconductor fine particulate layer 10b upon being excited by light.

Examples of sensitizing dyes include organic dyes such as azo dyes, cyanine dyes, merocyanine dyes, oxonol dyes, xanthene dyes, squarylium dyes, polymethine dyes, coumarin dyes, riboflavin dyes, and perylene dyes; and metal complex dyes such as phthalocyanine complexes and porphyrin complexes of metals such as iron, copper and ruthenium, and ruthenium bipyridine complexes such as di-tetrabutylammonium cis-bis(isothiocyanato)bis(2,2'-bipyridyl-4,4'-dicarboxylato)ruthenium(II) (commonly referred to as "N-719"). These sensitizing dyes may be used alone or in combination.

The sensitizing dye layer 10c can be formed by any method known in the art, such as a method in which the porous semiconductor fine particulate layer 10b is immersed in a sensitizing dye solution, or a method in which a sensitizing dye solution is applied onto the porous semiconductor fine particulate layer 10b. Immersion temperature and drying time may be selected as appropriate. The water content in the sensitizing dye solution and humidity in the drying atmosphere are preferably small.

The solvent used for the sensitizing dye solution can be selected as appropriate depending on the solubility of the sensitizing dye. Examples of the solvent include alcohols such as ethanol and isopropanol, ethers such as diethyl ether, ketones such as acetone, nitriles such as acetonitrile, sulfones such as dimethyl sulfoxide, amines such as N-methylpyrrolidone, and amides such as dimethylformamide. These solvents may be used alone or in combination.

Carboxylic acids such as choric acid or deoxychoric acid may be added to the dye solution as a co-adsorbent in order to reduce, for example, association of dye.

The photoelectrode is not limited to that illustrated in FIG. 1. Any of the photoelectrodes for dye-sensitized solar cell known in the art can be used so long as the photoelectrode may release electrons to the external circuit 40 upon receipt of light.

The electrolyte layer 20 is a layer that is provided in order to separate the photoelectrode 10 and the counter electrode 30, and also in order to enable efficient charge movement.

The electrolyte layer 20 typically contains a supporting electrolyte, a redox couple (i.e., a couple of chemical species that can be reversibly converted between in a redox reaction in the form of an oxidant and a reductant), a solvent, and so forth.

Examples of the supporting electrolyte include salts having a cation such as metal ion (e.g., lithium ion, sodium ion), pirydinium ion, imidazolium ion, or quaternary ammonium ion. These supporting electrolytes may be used alone or in combination. The ion concentration of these supporting electrolytes is normally 0.01M to 10M.

Any of the redox couples known in the art can be used so long as the redox couple may reduce the oxidized sensitizing dye. Examples thereof include chlorine compound/chlorine, iodine compound/iodine, bromine compound/bromine, thallium(III) ions/thallium(I) ions, ruthenium(III) ions/ruthenium(II) ions, copper(II) ions/copper(I) ions, iron(III) ions/iron(II) ions, cobalt(III) ions/cobalt(II) ions, vanadium(III) ions/vanadium(II) ions, manganic acid ions/permanganic acid ions, ferricyanide/ferrocyanide, quinone/hydroquinone, and fumaric acid/succinic acid. These redox couples may be used alone or in combination.

Any of the solvents known as solvents for forming electrolyte layers of solar cells in the art can be used. Examples of the solvent include acetonitrile, methoxyacetonitrile, methoxypropionitrile, N,N-dimethylformamide, ethyl methyl imidazolium bis(trifluoromethylsufonyl)imide, propylene carbonate, cyclopentyl methyl ether, γ-butyl lactone, ethylene glycol, triethylene glycol, and diethylene glycol momomethyl ether. Solvents with a boiling point of 150° or above are preferred. These solvents may be used alone or in combination.

For thickening and gelling of the electrolyte layer, gelling agents, polymers, cross-linkable monomers, inorganic particles such as titanium particles, and the like may be dissolved or dispersed in the solvent.

The electrolyte layer 20 can be formed for example by a method in which a solution containing its constituent component (electrolysis solution) is applied onto the photoelectrode 10 (or counter electrode 30) and then the photoelectrode 10 (or counter electrode 30) is attached to the counter electrode 30 (or photoelectrode 10) (One Drop Fill (ODF) method), or a method in which a cell having the photoelectrode 10 and counter electrode 30 is fabricated, and an electrolysis solution is injected in the cell through a gap or through an injection hole previously provided (end sealing method).

The counter electrode 30 is the counter electrode disclosed herein, which includes a support 30a. a conductive film 30c optionally formed on the support 30a, and a catalyst layer 30b formed on the conductive film 30c. The catalyst layer 30b contains the carbon nanotubes (A) as the constituent material, and is free of metal in this particular example.

In the dye-sensitized solar cell illustrated in FIG. 1, light energy is converted to electric energy by repeating a cycle such as that described below. Specifically, (i) electrons of the sensitizing dye 10c are taken out when the sensitizing dye 10c is excited upon receipt of light. (ii) These electrons move out of the photoelectrode 10, pass through the external circuit 40 to the counter electrode 30, and move into the electrolyte layer 20 through the catalyst layer 30b of the counter electrode 30. (iii) By the redox couple (reducing agent) contained in the electrolyte layer 20, the sensitizing dye in the oxidized state is reduced and the sensitizing dye 10c is reproduced, i.e., the sensitizing dye is converted back into a state where it is capable of absorbing light again.

The dye-sensitized solar cell disclosed herein is not limited to that illustrated in FIG. 1 and may include, in addition to the photoelectrode, electrolyte layer and counter electrode, a functional layer such as protection layer, antireflection layer, gas barrier layer, antifouling layer, and ultraviolet absorbing layer: a short-circuit prevention layer formed of non-woven fabric, separator, spacer particles or the like for preventing a short circuit between the photoelectrode and counter electrode: a current collector wiring made of titanium, silver or the like; a current collector wiring protection film made of epoxy resin or UV curable resin for preventing corrosion of a current collector wiring by electrolysis solution; a sealing layer for preventing volatilization of electrolysis solution and for bonding together the photoelectrode and counter electrode; a lead for current extraction; and an outer package.

The dye-sensitized solar cell disclosed herein is not limited to one that uses the sun as a light source, and may use for example indoor illumination as a light source.

The dye-sensitized solar cell disclosed herein includes the counter electrode disclosed herein as a counter electrode. Accordingly, the dye-sensitized solar cell disclosed herein has a high conversion efficiency and is also superior in mass productivity.

The dye-sensitized solar cell disclosed herein can make use of the above-described characteristics in particular and is therefore advantageously used as a portable solar cell or indoor solar cell.

### [Solar Cell Module]

The solar cell module disclosed herein includes a plurality of dye-sensitized solar cells disclosed herein connected in series and/or parallel. Module structures known in the art include Z-type, W-type, parallel-type, current collector wiring type, and monolithic type.

The solar cell module disclosed herein can be obtained for example by arranging the dye-sensitized solar cells disclosed herein in a planar or curved array, disposing non-conductive partition walls between the cells, and electrically connecting the photoelectrodes and counter electrodes of the cells using conductive members.

Any number of dye-sensitized solar cells can be used, and the number of dye-sensitized solar cells can be appropriately determined according to the intended level of voltage.

### EXAMPLES

The following provides more specific explanation of this disclosure through Examples, which however shall not be construed as limiting this disclosure. Properties were evaluated through the methods described below.

### <Evaluation by Temperature Programmed Desorption>

Sample (CNTs or carbon black) was placed in a fully-automated thermal desorption spectrometer "TPD-1-ATw" (Bel Japan Inc.) and a carrier gas (He) was caused to flow at 50 mL/min. The amounts of CO and CO₂ desorption were obtained by raising the temperature from 150°C to 950°C at a heating rate of 5°C/minute to heat the sample, detecting CO and CO₂ produced during heating using a quadrupole mass spectrometer, and using the obtained amounts of CO and CO₂ gases to calculate the amounts (µmol) of the gases produced per 1 g of the sample.

### <Close Adherence of Catalyst Layer>

Using the counter electrode fabricated, the catalyst layer was evaluated for close adherence based on the criteria given below.

### [Evaluation Criteria]

Good: No change in state of catalyst layer occurs upon washing with toluene

Poor: Catalyst layer begins to peel off upon washing with toluene <Solid Zeta-Potential of Catalyst Layer>

The water dispersion used for the generation of the catalyst layer was applied onto a polyethylene naphthalate (PEN) film and dried for 5 minutes at 50°C to provide a sample. The sample thus obtained was cut into a 1 cm × 2 cm piece and measured for solid zeta-potential at room temperature in solution (pH 6) using a zeta-potential meter for solid specimen ("SurPASS", from Anton Paa; clamp cell for plane-shaped sample). The measured solid zeta-potential was evaluated based on the criteria given below.

### [Evaluation Criteria]

A: Solid zeta-potential is -10 mV to 0 mV
B: Solid zeta-potential is -20 mV to less than -10 mV
C: Solid zeta-potential is less than -20 mV

### <Cell Performance>

A solar simulator (PEC-L11, produced by Peccell Technologies Inc.) in which an AM1.5G filter was attached to a 150 W xenon lamp light source was used as a light source. The light intensity was adjusted to 1 sun (AM1.5G, 100 mW/cm² [Class A of JIS C8912]). A prepared dye-sensitized solar cell was connected to a sourcemeter (Series 2400 SourceMeter produced by Keithley Instruments) and the following current/voltage characteristic measurement was performed.

Output current was measured while changing bias voltage from 0 V to 0.8 V in 0.01 V units under 1 sun light-irradiation. The output current was measured for each voltage step by, after the voltage had been changed, integrating values from 0.05 seconds after the voltage change to 0.15 seconds after the voltage change. Measurement was also performed while changing the bias voltage in the reverse direction from 0.8 V to 0 V, and an average value for the forward direction and the reverse direction was taken to be a photoelectric current.

The results of the current/voltage characteristic measurement described above were used to calculate the open-circuit voltage (V), the fill factor, and the energy conversion efficiency (%). The short-circuit current density (mA/cm²) was also measured.

### (Example 1)

### <Preparation of CNTs>

SGCNTs were prepared by the super growth method in accordance with the contents of WO2006/011655.

A thermometer, a water-flow reflux condenser, and a stirrer were attached to a three-necked flask having a capacity of 500 mL. The flask was loaded with 1 g of the SGCNTs described above and 80 mL of sulfuric acid (produced by Tokyo Chemical Industry Co., Ltd., 96% purity). The three-necked flask was immersed in an oil bath at 155°C and once the internal temperature of the flask reached 130°C, the flask was stirred under heating for 6 hours for reaction.

After completion of the reaction, the reaction mass was allowed to stand for cooling to room temperature, and an operation of adding deionized water and decanting a supernatant was repeated until washing waste water was neutral (pH 6.8). Through the above, sulfuric acid treated SGCNTs having a mass of 29.6 g in a wet state were obtained.

The sulfuric acid treated SGCNTs thus obtained were dried for 1 hour at 100°C, and the amounts of CO and CO₂ desorption were measured. The results are shown in Table 1.

The sulfuric acid treated SGCNTs were mainly composed of single-walled CNTs and had a BET specific surface area of 900 m²/g and a micropore volume of 0.45 mL/g. Additionally, the average diameter (Av) was 3.2 nm, the diameter distribution (3σ) was 1.9 nm, and the ratio of diamter distribution to average diameter, 3σ/Av, was 0.59.

### <Manufacture of Counter Electrode>

A 30 mL glass container was loaded with 5 g of water, 1 g of ethanol, and 0.0025 g of the sulfuric acid treated SGCNTs.

The contents of the glass container were subjected to dispersion treatment for 2 hours using a bath-type ultrasonic cleaner (produced by Branson Ultrasonics Corporation, 5510J-MT, 42 kHz, 180 W) to yield a water dispersion.

Next, using a low pressure mercury lamp, an indium tin oxide (ITO) surface of an ITO sputtered polyethylene naphthalate film (ITO-PEN film, 200 µm film thickness, 200 nm ITO thickness, 15 Ω/square sheet resistance) was subjected to UV/ozone treatment for 5 minutes at an irradiation distance of 3 cm. The water dispersion was applied onto the UV/ozone treated-ITO surface using a bar coater (produced by Tester Sangyo Co., Ltd., SA-203, No. 10) to a coating thickness of 22.9 µm. The obtained coating film was dried for 2 hours at 23°C and 60% RH to provide a counter electrode.

The catalyst layer was evaluated for close adherence and solid zeta-potential. The results are shown in Table 1.

### <Manufacture of Photoelectrode>

A binder-free titanium oxide paste (PECC-C01-06 produced by Peccell Technologies, Inc.) was applied onto an indium tin oxide (ITO) surface of an ITO sputtered polyethylene naphthalate film (ITO-PEN film, 200 µm film thickness, 200 nm ITO thickness, 15 Ω/square sheet resistance) using a Baker-type applicator to a coating thickness of 150 µm. The obtained coating film was dried for 10 minutes at normal temperature and was subsequently dried for 5 minutes under heating in a 150°C-thermostatic bath to provide a laminate of the ITO-PEN film and a porous semiconductor fine particulate layer.

The laminate was cut to 2.0 cm in length and 1.2 cm in width, and the porous semiconductor fine particulate layer was shaped into a circle having a diameter of 6 mm, 2 mm inward from a short side of the laminate. The resultant laminate was immersed into a sensitizing dye solution (sensitizing dye: ruthenium complex [N719 produced by Solaronix], solvent: acetonitrile, tert-butanol, concentration: 0.4 mM) for 2 hours at 40°C to cause adsorption of the sensitizing dye onto the porous semiconductor fine particulate layer. After the immersion treatment, the laminate was washed with acetonitrile and dried to provide a photoelectrode.

### <Preparation of Electrolysis Solution>

Iodine, lithium iodide, t-butylpyridine, and 1,2-dimethyl-3-propylimidazolium iodide were dissolved in methoxyacetonitrile to prepare an electrolysis solution containing 0.05 mol/L of iodine, 0.1 mol/L of lithium iodide, 0.5 mol/L of t-butylpyridine, and 0.6 mol/L of 1.2-dimethyl-3-propylimidazolium iodide.

### <Manufacture of Dye-Sensitized Solar Cell>

A spacer film was prepared by cutting out a 14 mm square from Surlyn film (25 µm thickness, produced by DuPont) and removing a central section of 9 mm in diameter. The counter electrode and the photoelectrode were placed in opposition to one another with the spacer film in-between and with conductive surfaces thereof facing inward, and were subjected to thermal compression bonding for 1 minute on a hot press heated to 110°C.

After allowing cooling to occur, a hole was opened in the counter electrode and the electrolysis solution was poured in through the hole. After pouring of the electrolysis solution, the hole through which the electrolysis solution was poured was sealed with Surlyn film (25 µm thickness, produced by DuPont) to obtain a dye-sensitized solar cell.

The dye-sensitized solar cell was evaluated for cell performance. The results are shown in Table 1.

### (Example 2)

A counter electrode was prepared as in Example 1 except that a PEN film was used instead of the ITO/PEN film. A dye-sensitized solar cell obtained using the prepared counter electrode was evaluated. The results are shown in Table 1.

### (Example 3)

A counter electrode was prepared as in Example 1 except that a PEN film was used instead of the ITO/PEN film and that an operation of applying the water dispersion onto the PEN film and drying the water dispersion was repeated 3 times. A dye-sensitized solar cell obtained using the prepared counter electrode was evaluated. The results are shown in Table 1.

### (Example 4) for reference

A counter electrode was prepared as in Example 1 except that non-treated SGCNTs were used instead of the sulfuric acid treated SGCNTs and that a PEN film was used instead of the ITO/PEN film. A dye-sensitized solar cell obtained using the prepared counter electrode was evaluated. The results are shown in Table 1.

### (Example 5)

A counter electrode was prepared as in Example 1 except that a mixture of the sulfuric acid treated SGCNTs and conductive carbon Ketjen black (EC600JD, produced from Lion Corporation) (sulfuric acid treated SGCNTs: Ketjen black (KB) = 80:20 (mass ratio)) was used instead of the sulfuric acid treated SGCNTs. A dye-sensitized solar cell obtained using the prepared counter electrode was evaluated. The results are shown in Table 1.

### (Example 6) for reference

A counter electrode was prepared as in Example 1 except that a mixture of non-treated SGCNTs and conductive carbon Ketjen black (EC600JD, produced from Lion Corporation) (non-treated SGCNT: Ketjen black (KB) = 80:20 (mass ratio)) was used instead of the sulfuric acid treated SGCNTs. A dye-sensitized solar cell obtained using the prepared counter electrode was evaluated. The results are shown in Table 1.

### (Comparative Example 1)

A counter electrode was prepared as in Example 1 except that single-walled carbon nanotubes (HiPco(registered trademark in Japan, other countries, or both), produced from NanoIntegris Inc.; average diameter (Av): 1.1 nm, standard deviation of diameters (σ): 0.067 nm, 3σ/Av: 0.18) was used instead of the sulfuric acid treated SGCNTs. A dye-sensitized solar cell obtained using the prepared counter electrode was evaluated. The results are shown in Table 1.

In Comparative Example 1, measurement of the solid zeta-potential failed due to falling of the single-wall carbon nanotubes (HiPco) during measurement.

### (Comparative Example 2)

A counter electrode was prepared as in Comparative Example 1 except that during manufacture of the counter electrode a water dispersion was prepared by using 300 parts by mass of dispersant sodium salt of carboxymethyl cellulose (CMC-Na) per 100 parts by mass of the single-wall carbon nanotubes and the water dispersion was dried for 10 minutes at 100°C in an oven (DN410I, Yamato Scientific Co., Ltd.) to provide the counter electrode. A dye-sensitized solar cell obtained using the prepared counter electrode was evaluated. The results are shown in Table 1.

### (Comparative Example 3)

A counter electrode was prepared as in Example 1 except that carbon black (DENKA BLACK (registered trademark in Japan, other countries, or both), produced by Denka Company Ltd.) was used instead of the sulfuric acid treated SGCNTs. A dye-sensitized solar cell obtained using the prepared counter electrode was evaluated. The results are shown in Table 1.

In Comparative Example 3, measurement of the solid zeta-potential failed due to falling of the carbon nanotubes during measurement.

### (Comparative Example 4)

A counter electrode was prepared as in Example 1 except that ozone treated SGCNTs prepared as described below was used instead of the sulfuric acid treated SGCNTs. A dye-sensitized solar cell obtained using the prepared counter electrode was evaluated. The results are shown in Table 1.

### <Preparation of Ozone Treated SGCNTs>

A recovery flask with a capacity of 500 mL was charged with 1 g of the SGCNTs prepared by the super growth method, and the recovery flask was connected to an evaporator. At normal pressure a flow of a mixture gas of ozone and air from an ozone generator was supplied to the gas channel of the evaporator at a flow rate of 600 mL/min and at an ozone concentration of 20 g/Nm³, and the recovery flask was rotated by the evaporator for 2.5 hours at room temperature for reaction with the SGCNTs to yield ozone treated SGCNTs. The ozone treated SGCNTs were measured for the amounts of CO and CO₂ desorption as in Example 1.

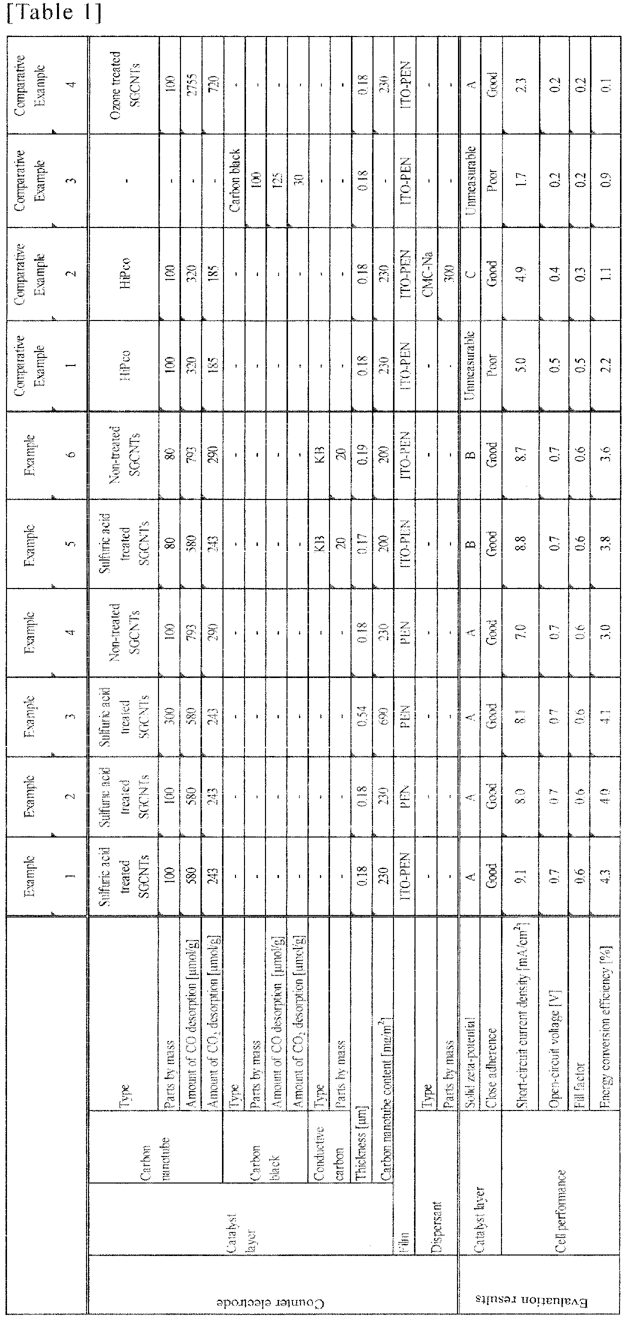

The results shown in Table 1 reveal that Examples 1 to 6 wherein specific CNTs were used were able to provide a counter electrode having a catalyst layer that exhibits superior characteristics, and a dye-sensitized solar cell that exhibits superior cell characteristics.

The results of Examples 1 to 6 and Comparative Example 2 shown in Table 1 reveal that Examples 1 to 6 wherein CNTs having specific amounts of CO and CO₂ desorption were able to provide a catalyst layer that exhibits superior catalytic activity because the CNTs were well dispersed even without using any dispersant.

### INDUSTRIAL APPLICABILITY

According to this disclosure, there is provided a counter electrode for dye-sensitized solar cell which is superior in catalytic activity and further suitable for mass production, a dye-sensitized solar cell including the counter electrode, and a solar cell module obtained using the dye-sensitized solar cell.

### REFERENCE SIGNS LIST

- 10: photoeclectrode (transparent electrode)
- 10a: photoelectrode base plate
- 10b: porous semiconductor fine particulate layer
- 10c: sensitizing dye layer
- 10d: support
- 10c: conductive film
- 10d: electrolyte layer
- 30: counter electrode
- 30a: support
- 30b: catalyst layer
- 30c: conductive film
- 40: external circuit

## Claims

1. A counter electrode for dye-sensitized solar cell, comprising:
a support; and
a catalyst layer formed on or over the support,
wherein the catalyst layer contains at least carbon nanotubes having a carbon monoxide desorption of 400 µmol/g to 1,000 µmol/g and a carbon dioxide desorption of 200 µmol/g to 600 µmol/g, as measured at from 150°C to 950°C in temperature programmed desorption, wherein
the catalyst layer has a solid zeta-potential of +20 mV to -20 mV and contains the carbon nanotubes in an amount of 5 mg/m² to 1 × 10³ mg/m², and
the carbon nanotubes are sulfuric acid-treated carbon nanotubes.

2. The counter electrode for dye-sensitized solar cell of claim 1, wherein the carbon nanotubes satisfy the condition 0.20<(3σ/Av)<0.60, where Av is an average diameter of the carbon nanotubes, and σ is a standard deviation of diameters of the carbon nanotubes.

3. The counter electrode for dye-sensitized solar cell of claim 1 or 2, wherein the catalyst layer has a thickness of 0.005 µm to 100 µm.

4. The counter electrode for dye-sensitized solar cell of any one of claims 1 to 3, wherein the catalyst layer further contains conductive carbon which is different from the carbon nanotubes.

5. The counter electrode for dye-sensitized solar cell of claim 4, wherein a mass content ratio of the carbon nanotubes to the conductive carbon (carbon nanotubes/conductive carbon) is 1/99 to 99/1.

6. A dye-sensitized solar cell comprising, in order:
a photoelectrode;
an electrolyte layer; and
a counter electrode,
wherein the counter electrode is the counter electrode for dye-sensitized solar cell of any one of claims 1 to 5.

7. A solar cell module comprising the dye-sensitized solar cells of claim 6 connected in series and/or parallel.

## Patentansprüche

1. Gegenelektrode für farbstoffsensibilisierte Solarzelle, umfassend:
einen Träger; und
eine Katalysatorschicht, die sich auf oder über dem Träger befindet,
wobei die Katalysatorschicht mindestens Kohlenstoffnanoröhren mit einer Kohlenmonoxiddesorption von 400 µmol/g bis 1000 µmol/g und einer Kohlendioxiddesorption von 200 µmol/g bis 600 µmol/g, gemessen bei 150° C bis 950° C bei temperaturprogrammierter Desorption, enthält, wobei
die Katalysatorschicht ein festes Zeta-Potential von +20 mV bis -20 mV aufweist und die Kohlenstoffnanoröhren in einer Menge von 5 mg/m² bis 1 × 10³ mg/m² enthält, und
die Kohlenstoffnanoröhren sind mit Schwefelsäure behandelte Kohlenstoff-Nanoröhren.

2. Gegenelektrode für eine farbstoffsensibilisierte Solarzelle nach Anspruch 1, wobei die Kohlenstoffnanoröhren die Bedingung 0,20<(3σ/Av)<0,60 erfüllen, wobei Av ein durchschnittlicher Durchmesser der Kohlenstoffnanoröhren ist und σ eine Standardabweichung der Durchmesser der Kohlenstoffnanoröhren ist.

3. Gegenelektrode für farbstoffsensibilisierte Solarzelle nach Anspruch 1 oder 2, wobei die Katalysatorschicht eine Dicke von 0,005 µm bis 100 µm aufweist.

4. Gegenelektrode für eine farbstoffsensibilisierte Solarzelle nach einem der Ansprüche 1 bis 3, wobei die Katalysatorschicht weiterhin leitfähigen Kohlenstoff enthält, der sich von den Kohlenstoffnanoröhren unterscheidet.

5. Gegenelektrode für eine farbstoffsensibilisierte Solarzelle nach Anspruch 4, wobei das Massenverhältnis der Kohlenstoffnanoröhren zum leitfähigen Kohlenstoff (Kohlenstoffnanoröhren/leitfähiger Kohlenstoff) 1/99 bis 99/1 beträgt.

6. Farbstoffsensibilisierte Solarzelle, die der Reihe nach umfasst:
eine Fotoelektrode;
eine Elektrolytschicht; und
eine Gegenelektrode,
wobei die Gegenelektrode die Gegenelektrode für eine farbstoffsensibilisierte Solarzelle nach einem der Ansprüche 1 bis 5 ist.

7. Solarzellenmodul umfassend die farbstoffsensibilisierten Solarzellen nach Anspruch 6 in Reihe und/oder parallel geschaltet.

## Revendications

1. Contre-électrode pour cellule solaire à colorant, comprenant :
un support ; et
une couche de catalyseur formée sur le support ou au-dessus de celui-ci,
dans laquelle la couche de catalyseur contient au moins des nanotubes de carbone présentant une désorption de monoxyde de carbone de 400 µmol/g à 1 000 µmol/g et une désorption de dioxyde de carbone de 200 µmol/g à 600 µmol/g, telles que mesurée entre 150 °C à 950 °C dans une désorption en température programmée, dans laquelle
la couche de catalyseur a un potentiel zêta de solides de + 20 mV à - 20 mV et contient les nanotubes de carbone dans une quantité de 5 mg/m² à 1 × 10³ mg/m², et
les nanotubes de carbone sont des nanotubes de carbone traités à l'acide sulfurique.

2. Contre-électrode pour cellule solaire à colorant selon la revendication 1, dans laquelle les nanotubes de carbone satisfont la condition 0,20 < (3σ/Av) < 0,60, où Av est un diamètre moyen des nanotubes de carbone, et σ est un écart standard de diamètres des nanotubes de carbone.

3. Contre-électrode pour cellule solaire à colorant selon la revendication 1 ou 2, dans laquelle la couche de catalyseur a une épaisseur de 0,005 µm à 100 µm.

4. Contre-électrode pour cellule solaire à colorant selon l'une quelconque des revendications 1 à 3, dans laquelle la couche de catalyseur contient en outre du carbone conducteur qui est différent des nanotubes de carbone.

5. Contre-électrode pour cellule solaire à colorant selon la revendication 4, dans laquelle un rapport de teneur en masse des nanotubes de carbone sur le carbone conducteur (nanotubes de carbone/carbone conducteur) est de 1/99 à 99/1.

6. Cellule solaire à colorant comprenant, dans l'ordre :
une photoélectrode ;
une couche d'électrolyte ; et
une contre-électrode,
dans laquelle la contre-électrode est la contre-électrode pour cellule solaire à colorant selon l'une quelconque des revendications 1 à 5.

7. Module de cellules solaires comprenant les cellules solaires à colorant selon la revendication 6 connectées en série et/ou parallèle.
